# EUROPEAN PATENT SPECIFICATION

(11) **EP 3 858 162 B1**
(45) Date of publication and mention of the grant of the patent: **07.09.2022**
(21) Application number: 20877513.0
(22) Date of filing: 25.03.2020
(51) Int. Cl.: A24F 40/05, A24F 40/40, A24F 40/10

(54) **VARIABLE-FREQUENCY SURFACE ACOUSTIC WAVE E-CIGARETTE**
E-ZIGARETTE MIT OBERFLÄCHENSCHALLWELLEN MIT VARIABLER FREQUENZ
CIGARETTE ÉLECTRONIQUE À ONDES ACOUSTIQUES DE SURFACE À FRÉQUENCE VARIABLE

(30) Priority: 26.02.2020 CN 202010120537
(43) Date of publication of application: 04.08.2021
(73) Proprietor: China Tobacco Yunnan Industrial Co., Ltd, Kunming, Yunnan 650231 (CN)
(72) Inventor: LI, Tinghua, Kunming, Yunnan 650231 (CN); LEI, Yulin, Kunming, Yunnan 650231 (CN); HAN, Yi, Kunming, Yunnan 650231 (CN); WU, Jun, Kunming, Yunnan 650231 (CN); CHEN, Yongkuan, Kunming, Yunnan 650231 (CN); ZHU, DongLai, Kunming, Yunnan 650231 (CN); HU, Hong, Kunming, Yunnan 650231 (CN); TANG, Jianguo, Kunming, Yunnan 650231 (CN); LI, Shou Bo, Kunming, Yunnan 650231 (CN); ZHAO, Wei, Kunming, Yunnan 650231 (CN); ZHANG, Xia, Kunming, Yunnan 650231 (CN); HONG, Liu, Kunming, Yunnan 650231 (CN); GONG, Xiaowei, Kunming, Yunnan 650231 (CN); LV, Xi, Kunming, Yunnan 650231 (CN)
(74) Representative: Gille Hrabal Partnerschaftsgesellschaft mbB Patentanwälte
(86) International application number: PCT/CN2020/081117
(87) International publication number: WO 2021/073045

(56) References cited:
- CA-A1- 3 013 531
- CA-A1- 3 096 355
- CN-A- 107 819 448
- CN-A- 109 480 335
- CN-A- 110 587 977
- CN-U- 208 353 309
- CN-U- 208 353 309
- US-A1- 2015 270 826

## Description

### TECHNICAL FIELD

The present invention belongs to the technical field of electronic cigarettes, and more particularly, relates to a variable-frequency surface acoustic wave electronic cigarette.

### BACKGROUND

At present, electrically-heated atomizing electronic cigarettes occupy the mainstream market of electronic cigarettes. They use resistance wires for heating to generate localized high temperatures so that the e-liquid in the cotton core or porous ceramic sheet is atomized to form an aerosol for users to smoke. The electrically-heated atomizing electronic cigarette has a substantial rate of heat conduction and atomization efficiency. Under the action of high temperature, however, harmful substances such as formaldehyde, carbon monoxide and others are easily produced, which not only causes health and safety risks, but also greatly reduces the experience of smoking. Another type of electronic cigarette is an ultrasonic atomizing electronic cigarette. The ultrasonic atomizing electronic cigarette requires a thin layer of e-liquid to be evenly spread on an entire surface of an atomizing sheet to realize atomization. If the e-liquid accumulates, the amount of smoke created will vary, sometimes large and sometimes small during use of the electronic cigarette, and even the smoke with a large particle size will be produced. When such smoke is inhaled into the mouth along an airflow channel by the user, it will reduce the user experience. In addition, the amount of smoke through the pure ultrasonic atomization is smaller than that of the electrically-heated atomization, and an auxiliary ceramic heating sheet is required to increase the amount of smoke to satisfy the user's experience demand for hot smoke.

In order to solve the aforementioned problems, the applicant designed an electronic cigarette system, which uses a surface acoustic wave to achieve atomization of e-liquid (refer to the Chinese Patent ZL201810076941.1). The electronic cigarette system effectively prevents the potential safety and health risks caused by rapid high heat of the electrically-heated atomization, and solves the problems of high consumption, lower efficiency and poor experience of the ultrasonic atomization. After atomization of the e-liquid using such system, however, the smoke particle size is basically determined and cannot be adjusted arbitrarily, thereby affecting the smoking experience.

CA3013531 concerns a known electronic cigarette using a surface acoustic wave transducer.

In order to solve the above problems, the present invention is proposed.

### SUMMARY

The present invention provides a variable-frequency surface acoustic wave electronic cigarette, which realizes atomization of e-liquid using the diffraction energy of the surface acoustic wave, and enables a range of a surface acoustic wave frequency to be adjustable through a structural design of a special atomization chip to further realize the effective adjustment of a smoke particle size after the atomization of the e-liquid. The electronic cigarette of the present invention has a simple overall structure, convenient assembly, and high atomization efficiency, and can effectively satisfy users' different smoking experiences.

The present invention provides a variable-frequency surface acoustic wave electronic cigarette, which includes an atomizer 2. An atomization cavity 213 is disposed in the atomizer 2, and a variable-frequency surface acoustic wave atomization chip 203 is disposed at a lower portion of the atomization cavity 213. An inverted trapezoidal interdigital transducer 2037 is disposed on the variable-frequency surface acoustic wave atomization chip 203. An e-liquid storage cavity 205 is disposed in the atomization cavity 213. A porous ceramic sheet 204 is disposed between the e-liquid storage cavity 205 and the atomization chip 203.

According to the invention, the inverted trapezoidal interdigital transducer 2037 includes a plurality of metal interdigital electrodes *a*, *b* and reflective electrodes c, which are in an inverted trapezoidal shape. The inverted trapezoidal interdigital transducer 2037 further includes two metal electrode bus bars, namely a first metal electrode bus bar 20361 and a second metal electrode bus bar 20362. A plurality of first metal interdigital electrodes *a* are connected to the first metal electrode bus bar 20361 through a relatively long trapezoidal bottom, and a plurality of second metal interdigital electrodes b are connected to the second metal electrode bus bar 20362 through a relatively short trapezoidal bottom. The plurality of first metal interdigital electrodes *a* and the plurality of second metal interdigital electrodes b are arranged in a finger-crossed shape, and a reflective electrode c is embedded between a first metal interdigital electrode *a* and a second metal interdigital electrode b.

Preferably, an arrangement manner of the metal interdigital electrodes and reflective electrodes is: the first metal interdigital electrode *a*, a first gap *d₁,* the second metal interdigital electrode *b,* a second gap *d₂*, the reflective electrode c, a third gap *d₃*, the first metal interdigital electrode *a*, .... The above arrangement continues in a plurality of groups to constitute the inverted trapezoidal interdigital transducer 2037. An average width of the first gap *d₁* is identical to an average width of the first metal interdigital electrode *a.* An average width of the second gap *d₂* is identical to an average width of the second metal interdigital electrode *b.* An average width of the third gap *d₃* is identical to an average width of the reflective electrode c.

Preferably, a shape of the first metal interdigital electrode *a* and a shape of the second metal interdigital electrode b are identical. The sum of the average width of the first metal interdigital electrode *a*, the average width of the first gap *d₁*, the average width of the second metal interdigital electrode b, the average width of the second gap *d₂*, the average width of the reflective electrode c and the average width of the third gap *d₃* is a wavelength *p* of the surface acoustic wave. It is satisfied that the average width of the first metal interdigital electrode *a*, or the average width of the first gap *d₁*, or the average width of the second metal interdigital electrode b or the average width of the second gap *d₂* is one eighth of the wavelength of the surface acoustic wave, and the average width of the third gap *d₃* or the average width of the reflective electrode c is a quarter of the wavelength of the surface acoustic wave.

Preferably, the atomization chip 203 further successively includes: a heat sink layer 2031, a heat conduction layer 2032 and a piezoelectric substrate layer 2033. The inverted trapezoidal interdigital transducer 2037 is disposed on the piezoelectric substrate layer 2033. Two separate printed circuit board PCB bonding pads, namely a first PCB bonding pad 20341 and a second PCB bonding pad 20342, are further disposed on the piezoelectric substrate layer 2033. The first metal electrode bus bar 20361 is connected to the first PCB bonding pad 20341 through a power connection wire 2035, and the second metal electrode bus bar 20362 is connected to the second PCB bonding pad 20342 through a power connection wire 2035.

Preferably, the electronic cigarette further includes an electric core 3. A circuit board 307 and a battery 305 are disposed in the electric core 3, and the electric core 3 is conductively connected to the first PCB bonding pad 20341 and the second PCB bonding pad 20342 through a magnetic thimble 212.

Preferably, the atomizer 2 is provided with an atomizer housing 209. An airflow channel 208 is disposed inside the atomizer housing 209, and a suction nozzle 1 is disposed outside the atomizer housing 209. The suction nozzle 1 is in communication with and connected to the airflow channel 208. An airflow inlet 210 is formed on the atomizer housing 209, and the airflow inlet 210 and the inverted trapezoidal interdigital transducer 2037 are on an identical horizontal plane.

Preferably, the electronic cigarette further includes a protective shell 301. The electric core 3 is disposed in the protective shell 301. A button 5, an indicator light 6 and a charging port 302 are disposed outside the protective shell 301.

The present invention has the following advantages.
1. The surface acoustic wave is a kind of mechanical wave, of which energy is concentrated on the surface. The energy loss in a propagation direction is small (even negligible without interference from other medias). The energy is exponentially attenuated in a direction perpendicular to the propagation direction of the wave. The range of the vibration frequency of the surface acoustic wave is as high as GHz, and is an order of magnitude higher than an ultrasound wave. In the e-liquid atomization system based the vibration of the substrate, the smoke particle size is directly related to the vibration frequency, which satisfies *D* =*KγH²We*^{*2*/*3*}/*µL² f* , where *D* is an atomized smoke particle size, *K* is a proportional coefficient, γ is a surface tension of atomized fluid, *H* is a characteristic height of a fluid film to be atomized, *We* is an acoustic Weber number, *µ* is a dynamic viscosity coefficient of the fluid, *L* is a characteristic width of the fluid to be atomized, and f is a vibration frequency of the substrate). It is easy to discover that the smoke particle size is inversely proportional to the vibration frequency. Thus, such a high frequency of the surface acoustic wave makes its atomized smoke particle size much smaller than the atomized smoke particle size of the ultrasonic wave. In this way, the problems of deposition in the lung and damage to the body caused by the inhalation of smoke with the large particle size are not only reduced effectively, but also the taste of the e-liquid increases as the smoke particle size decreases to increase the user's smoking experience.
2. The atomization chip in the present invention adopts a structure of one-way apodization interdigital electrode through electrode width control. The inventive point lies in adopting the electrode width control method, that is, the reflective electrode is embedded inside the inverted trapezoidal interdigital transducer to enable the acoustic wave to only propagate along a single direction, so that the whole energy of the acoustic wave are all used to atomize the e-liquid. Moreover, a finger-shaped strip structure of the metal interdigital electrode is converted into an inverted trapezoidal structure in which the width of the electrode gradually changes from top to bottom, so that the frequency of the atomization chip is no longer singly fixed, but has a variable-frequency range. In this way, the user can adjust the frequency range arbitrarily according to personal needs to obtain the atomized smoke with different particle sizes, which not only can satisfy the user's personalized needs for the smoke particle size, but also can bring the user different smoking experiences.
3. When the variable-frequency surface acoustic wave electronic cigarette of the present invention is used, under the premise that the normal sucking function of the electronic cigarette is satisfied, a temperature of the surface of the atomization chip is maintained at about 100°C, which is much lower than a heating and atomizing temperature (180-350°C) of the electrically-heated atomizing electronic cigarette, so the safety hazard problems such as the release of aldehyde chemicals, carbonization, and core burning caused by the electrically-heated high temperature can be effectively prevented. In additionally, compared with the cold smoke produced by the ultrasonic atomizing electronic cigarette, the smoke produced by the surface acoustic wave electronic cigarette has a better temperature experience.
4. The variable-frequency surface acoustic wave atomization chip of the present invention adopts a lithium niobate single crystal atomization chip, and the atomization chip can maintain a normal working mode when its surface is not in contact with the e-liquid, which is represented in the transmission and reflection of mechanical waves on the surface of the atomization chip, and the phenomenon of dry burning produced when the supply of e-liquid is insufficient does not occur. Therefore, the variable-frequency surface acoustic wave electronic cigarette of the present invention will not affect or damage the atomization chip and the atomizer when the e-liquid is exhausted, and is thus stable and reliable.
5. The variable-frequency surface acoustic wave electronic cigarette of the present invention adopts a light porous ceramic sheet with high porosity to realize the guiding and locking of the e-liquid. The e-liquid is sucked out from the porous ceramic sheet by the surface acoustic wave during atomization to automatically form a liquid film between the porous ceramic sheet and the atomization chip, and an atomizing function is performed in an area of the liquid film. When the atomization chip stops working, the e-liquid will automatically retract into the porous ceramic sheet. Therefore, the variable-frequency surface acoustic wave electronic cigarette of the present invention can effectively avoid the problems existing in the ultrasonic atomizing electronic cigarette, that is, the fluctuations of the amount of smoke or relatively large smoke particle sizes caused by uneven distribution of the e-liquid or accumulation of the e-liquid can be avoided.

### BRIEF DESCRIPTION OF THE DRAWINGS

FIG. 1 is a schematic diagram of the structure of a variable-frequency surface acoustic wave electronic cigarette of the present invention.
FIG. 2 is an exploded view of the variable-frequency surface acoustic wave electronic cigarette of the present invention.
FIG. 3 is a cross-sectional view of an atomizer of the present invention.
FIG. 4 is an exploded view of the atomizer of the present invention.
FIG. 5 is a schematic diagram of the structure of an atomization chip of the present invention.

Reference signs: 1. suction nozzle; 2. atomizer; 3. electric core; 4. e-liquid injection hole; 5. button; 6. indicator light; 201. bottom board; 202. silicone gasket; 203. atomization chip; 204. porous ceramic sheet; 205. e-liquid storage cavity; 206. silicone sealing sheet; 207. first screw; 208. airflow channel; 209. atomizer housing; 210. airflow inlet; 211. atomization chip stopper; 212. magnetic thimble; 213. atomization cavity; 301. protective shell; 302. charging port; 303. stop body; 304. screw cap; 305. battery; 306. second screw; 307. circuit board; 308. bottom cover; 401. silicone e-liquid injection hole plug; 402. e-liquid injection round hole; 2031. heat sink; 2032. heat conduction layer; 2033. piezoelectric substrate layer; 20341. first PCB bonding pad; 20342. second PCB bonding pad; 2035. power connection wire; 20361. first metal electrode bus bar; 20362. second metal electrode bus bar; 2037. inverted trapezoidal interdigital transducer; *a.* first metal interdigital electrode; *b.* second metal interdigital electrode; c. reflective electrode; *d₁.* first gap; *d₂.* second gap; *d₃.* third gap; *p.* wavelength of surface acoustic wave; and W. internal range of inverted trapezoidal interdigital transducer.

### DETAILED DESCRIPTION OF THE EMBODIMENTS

In order to make the objects, technical solutions and advantages of the present invention clearer, the present invention will be further explained below in conjunction with the drawings and embodiments.

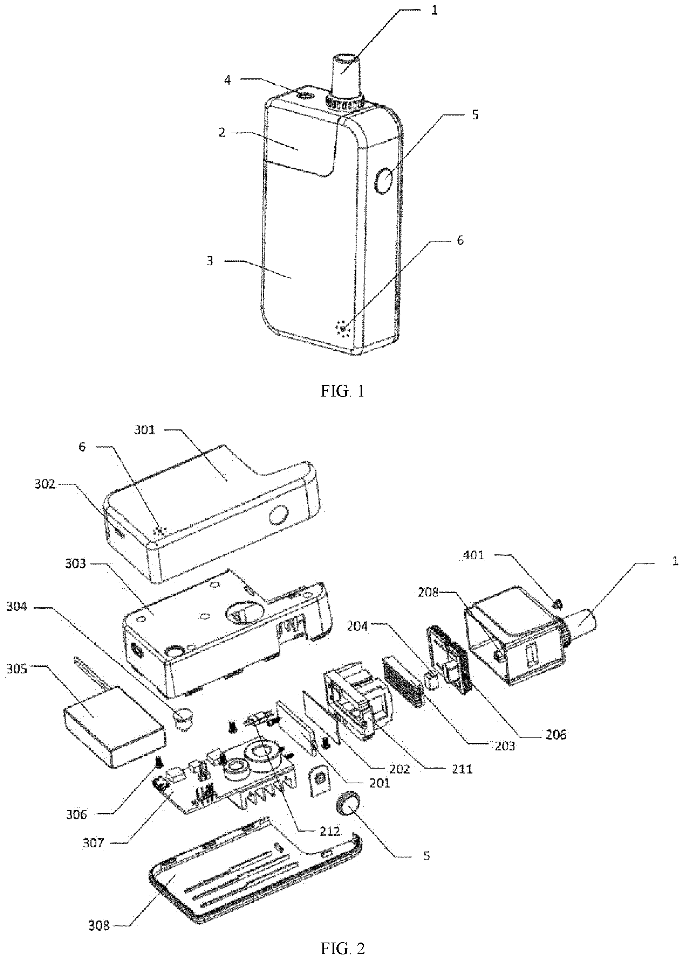

FIG. 1 shows a schematic diagram of the structure of a variable-frequency surface acoustic wave electronic cigarette of the present invention, which includes the suction nozzle 1, the atomizer 2, the electric core 3, the e-liquid injection hole 4, the button 5 and the indicator light 6. The atomizer 2 and the electric core 3 are firmly contiguously connected through the magnetic thimble 212. The suction nozzle 1 is configured for the user to smoke the smoke. The atomizer 2 is configured to atomize the e-liquid to produce the smoke. The electric core 3 is configured to provide a drive signal source to the atomizer 2. The e-liquid injection hole 4 is configured to fill the e-liquid. The button 5 is configured to realize operations of turning the electronic cigarette on and off, adjusting a frequency of the drive signal source and controlling an output of the signal source, and other operations. The indicator light 6 is configured to display the working status and electric quantity of the electronic cigarette.

FIG. 2 shows an exploded view of the variable-frequency surface acoustic wave electronic cigarette of the present invention. The suction nozzle 1 is located on the top of the atomizer 2. An internal structure of the atomizer includes the bottom board 201, the silicone gasket 202, the variable-frequency surface acoustic wave atomization chip 203, the porous ceramic sheet 204, the e-liquid storage cavity 205, the silicone sealing sheet 206, the first screw 207, the airflow channel 208, the atomizer housing 209, the airflow inlet 210, the atomization chip stopper 211, the magnetic thimble 212 and the atomization cavity 213. The electric core 3 is provided with the protective shell 301, the charging port 302, the stop body 303, the screw cap 304, the battery 305, the second screw 306, the circuit board 307 and the bottom cover 308. The e-liquid injection hole 4 is located on the top of the atomizer 2 and located on a side of the suction nozzle 1, and includes the silicone e-liquid injection hole plug 401 and the e-liquid injection round hole 402 located on the top of the atomizer. The button 5 is located on a side of the protective shell 301 of the electric core 3. The indicator light 6 is located on the lower right side of the protective shell 301 of the electric core 3. The atomization chip 203 successively includes the heat sink 2031, the heat conduction layer 2032, the piezoelectric substrate layer 2033, the first printed circuit board (PCB) bonding pad 20341, the second PCB bonding pad 20342, the power connection wire 2035, the first metal electrode bus bar 20361, the second metal electrode bus bar 20362, and the inverted trapezoidal interdigital transducer 2037. The atomizer housing 209 of the atomizer 2 and the protective shell 301 and the bottom cover 308 of the electric core 3 are all made of aluminum alloy materials having good heat conduction and heat dissipation effects. The porous ceramic sheet 204 is made of silicate materials having good porosity (the porosity is generally in the range of 40%-70%), high temperature and high pressure resistance and acid and alkali corrosion resistance. The heat sink 2031 is made of aluminum sheet having an excellent heat dissipation effect and a low cost, and the bottom of the heat sink 2031 is provided with grooves. The heat conduction layer 2032 is made of heat conduction silicone grease sheets having good bonding performance and heat conduction capability. The piezoelectric substrate layer 2033 selects a 128 ° lithium niobate single crystal chip propagating in a direction of Y being tangent to X, with a thickness of 1 mm-2 mm, an electromechanical coupling coefficient of 5.5%, a propagation velocity of the surface acoustic wave of about 3990 m/s, and a temperature coefficient of -72×10-6/°C. The power connection wire 2035 employs a gold wire or a silver wire, which has a diameter of reaching 100µm and can be used for a binding process. The first metal electrode bus bar 20361, the second metal electrode bus bar 20362 and the metal interdigital electrodes *a* and *b* are made of aluminum, silver, gold or other materials having good electrical conductivity. The structure of the metal interdigital electrodes *a* and *b* employs an apodization structure having crossed metal strips with a wide top and a narrow bottom, namely an inverted trapezoidal structure.

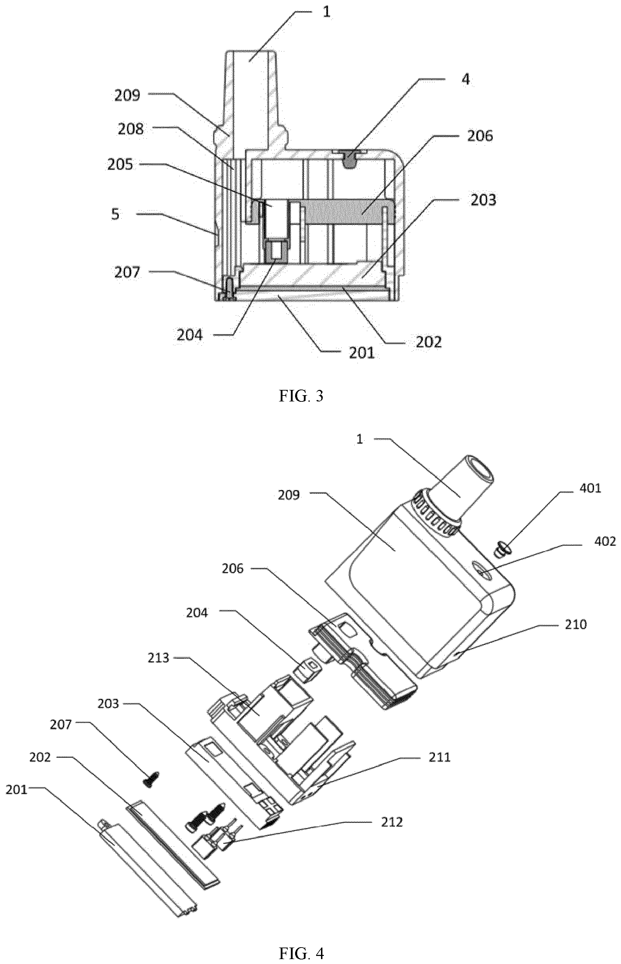

FIG. 3 and FIG. 4 show a cross-sectional view and an exploded view of the atomizer of the variable-frequency surface acoustic wave electronic cigarette of the present invention, respectively. The atomization chip 203 is placed in the atomization chip stopper 211, and the atomization cavity 213 is provided at the upper end of the atomization chip stopper 211. The e-liquid storage cavity 205 is provided at the lower end of the silicone sealing sheet 206. The porous ceramic sheet 204 employs a bowl-shaped structure with a convex portion around a middle recessed portion, and a size thereof are exactly matched with the lower port of the e-liquid storage cavity 205 to form a whole e-liquid storing and guiding structure. The assembled silicone sealing sheet 206 and porous ceramic sheet 204 are placed on the upper end of the atomization chip stopper 211. The e-liquid storage cavity 205 and the porous ceramic sheet 204 are exactly located in the atomization cavity 213. The porous ceramic sheet 204 is fitted with the upper surface of the atomization chip 203 to realize the supply and transmission of e-liquid. The magnetic thimble 212 is mounted at the right end of the atomization chip stopper 211, and is configured to access the drive signal source. The above assembly structure is placed in the atomizer housing 209, and a piece of silicone gasket 202 is pasted on the bottom of the above assembly structure to realize heat insulation and sealing. Finally, the bottom board 201 is covered, and the first screw 207 is screwed to fix the entire atomizer. The e-liquid is injected from the e-liquid injection round hole 402 on the top of the atomizer 2, and the entire e-liquid storage cavity 205 will be automatically fully filled after the e-liquid is injected. Finally, the silicone e-liquid injection hole plug 401 is inserted into the e-liquid injection round hole 402 for sealing. When the user performs a smoking action through the suction nozzle 1, the peripheral air flows in from the airflow inlet 210, and the airflow inlet 210 and the inverted trapezoidal interdigital transducer 2037 are on an identical horizontal plane. The air carries the e-liquid atomized smoke from the end surface of the porous ceramic sheet 204 disposed on the surface of the atomization chip 203 in the atomizer 2 to enter the suction nozzle 1 through the airflow channel 208 for the smoker to smoke.

In an embodiment, the electric core 3 of the above electronic cigarette further includes: the protective shell 301, the charging port 302, the stop body 303, the screw cap 304, the battery 305, the second screw 306, the circuit board 307 and the bottom cover 308. First, the circuit board 307 is placed in the stop body 303, and the battery 305 is placed at the lower part of the circuit board 307 to ensure that the charging port 302 of the circuit board 307 is aligned with the stop body 303. The button 5 is installed on a side of the protective shell 301 of the electric core 3, then the above assembly is placed in the protective shell 301, and the charging port is also ensured to be aligned with the charging port 302 of the bottom of the protective shell 301. The button 5 is connected to a button output port of the circuit board 307 through a wire. The magnetic thimble 212 is provided at the top of the protective shell 301, is connected to a signal output end of the circuit board 307 through the wire, and is fixed using the second screw 306 and the screw cap 304. After assembling, the indicator light 6 is exactly located on the lower right side of the protective shell 301 of the electric core 3. Finally, the bottom cover 308 is fastened to complete the assembling and connection of the electric core.

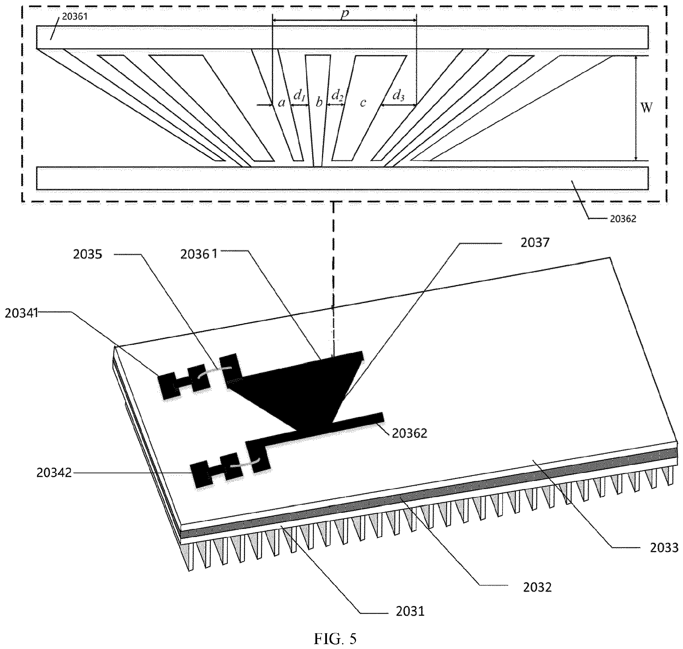

FIG. 5 shows a schematic diagram of the structure of the atomization chip of the variable-frequency surface acoustic wave electronic cigarette of the present invention., The atomization chip successively includes: the heat sink 2031, the heat conduction layer 2032, the piezoelectric substrate layer 2033, the first PCB bonding pad 20341, the second PCB bonding pad 20342, the power connection wire 2035, and the inverted trapezoidal interdigital transducer 2037. The inverted trapezoidal interdigital transducer 2037 includes two metal electrode bus bars, namely the first metal electrode bus bar 20361 and the second metal electrode bus bar 20362. A plurality of first metal interdigital electrodes *a* are connected to the first metal electrode bus bar 20361 through a relatively long trapezoidal bottom, and a plurality of second metal interdigital electrodes b are connected to the second metal electrode bus bar 20362 through a relatively short trapezoidal bottom. The plurality of the first metal interdigital electrodes *a* and the plurality of the second metal interdigital electrodes *b* are arranged in a finger-crossed shape. The reflective electrode c is embedded between the first metal interdigital electrode *a* and the second metal interdigital electrode *b,* and the reflective electrode c is not connected to any metal electrode bus bar. Each of the inverted trapezoidal interdigital transducer 2037, the first PCB bonding pad 20341, the second PCB bonding pad 20342 and the piezoelectric substrate layer 2033 is adhered to the upper surface of the heat sink 2031 through the heat conduction layer 2032. The first PCB bonding pad 20341 and the second PCB bonding pad 20342 are connected to the first metal electrode bus bar 20361 and the second metal electrode bus bar 20362 using the power connection wire 2035 through the binding process, respectively. The other end of the first PCB bonding pad 20341 and the other end of the second PCB bonding pad 20342 are assembled and connected through the magnetic thimble 212 disposed between the atomizer 2 and the electric core 3 to realize the input of the signal source.

The upper part of FIG. 5 shows the partial enlarged view of the shape of the inverted trapezoidal interdigital transducer 2037. A frequency of the surface acoustic wave generated by the atomization chip 203 is determined by the structure of the inverted trapezoidal interdigital transducer 2037. The arrangement manner of the metal interdigital electrodes and the reflective electrodes is: the first metal interdigital electrode *a*, the first gap *d₁*, the second metal interdigital electrode *b,* the second gap *d₂*, the reflective electrode c, the third gap *d₃*, the first metal interdigital electrode *a*, ..., and the above arrangement continues in a plurality of groups to constitute the inverted trapezoidal interdigital transducer 2037. The average width of the first gap *d₁* is identical to the average width of the first metal interdigital electrode *a.* The average width of the second gap *d₂* is identical to the average width of the second metal interdigital electrode *b.* The average width of the third gap *d₃* is identical to the average width of the reflective electrode c. In the present embodiment, the shape of the first metal interdigital electrode *a* and the shape of the second metal interdigital electrode *b* are completely identical, wherein the sum of the average width of the first metal interdigital electrode *a*, the average width of the first gap *d₁*, the average width of the second metal interdigital electrode *b,* the average width of the second gap *d₂*, the average width of the reflective electrode c and the average width of the third gap *d₃* is the wavelength *p* (i.e., *p = a*+*b*+*c*+*d₁*+*d₂*+*d₃*) of the surface acoustic wave, and it is satisfied that the average width of the first metal interdigital electrode *a*, or the average width of the first gap *d₁,* or the average width of the second metal interdigital electrode *b* or the average width of the second gap *d₂* is one eighth of the wavelength of the surface acoustic wave (i.e., *a = b = d₁ = d₂ = p*/*8*), and the average width of the third gap *d₃* or the average width of the reflective electrode c is a quarter of the wavelength of the surface acoustic wave (i.e., *c = d₃ = p*/*4*). For example, in order to realize that the frequency range of the generated surface acoustic wave is 20 MHz - 100 MHz, it is required that, within the W range of the inverted trapezoidal interdigital transducer 2037 (refer to the partial enlarged view at the upper part of FIG. 5), each of the uppermost end of the first metal interdigital electrode *a*, the uppermost end of the first gap *d₁*, the uppermost end of the second metal interdigital electrode b, and the uppermost end of the second gap *d₂* takes a value of 15 µm, and each of the lowermost end of the first metal interdigital electrode *a*, the lowermost end of the first gap *d₁*, the lowermost end of the second metal interdigital electrode b, and the lowermost end of the second gap *d₂* takes a value of 5 µm, that is, the change range of the wavelength is 200 µm - 40 µm.

A method for using the variable-frequency surface acoustic wave electronic cigarette of the present invention includes the following steps.

The electric core 3 is externally connected to a charging wire through the charging port 302 to complete the charging of the battery. The e-liquid is injected through the e-liquid injection hole 4, and the e-liquid fills the e-liquid storage cavity 205, then permeates into the porous ceramic sheet 204 and finally reaches the surface of the atomization chip 203 and is locked. The atomizer 2 is connected to the electric core 3 through the magnetic thimble 212. After the button 5 is turned on, the signal source and the atomization chip 203 realize the signal input and communication. Based on the inverse piezoelectric effect of the piezoelectric substrate layer 2033, the input electric signal is converted into a mechanical vibration signal to generate a surface acoustic wave propagating along the surface of the piezoelectric substrate layer 2033. When the surface acoustic wave is transmitted to a contact area of the porous ceramic sheet 204, the surface acoustic wave sucks out the e-liquid locked by the porous ceramic sheet 204, and a liquid film is formed between the surface of the piezoelectric substrate layer 2033 and the end surface of the porous ceramic sheet 204. The energy of the surface acoustic wave is diffracted into the liquid film of the e-liquid to produce an acoustic streaming effect and form an acoustic streaming force. The acoustic streaming force overcomes the surface tension and viscosity force of the liquid film of the e-liquid to enable the e-liquid to produce the smoke with a nano-sized particle size. Suction is performed through the suction nozzle 1, and the peripheral air flows in from the airflow inlet 210, flows through the e-liquid atomization area, and transmits the atomized smoke into the mouth of the user along the airflow channel 208 and the suction nozzle 1.

After the button 5 is long pressed to reach 5 s, the electric core 3 automatically stops the output to prevent excessive suction. The signal can be output normally by long pressing the button 5 again, so that the connected atomization chip 203 works normally and completes the atomization of the e-liquid. In a power-on state, the button 5 is pressed twice within 0.5 s to enter a frequency cycle adjustment mode. Each time the button 5 is pressed twice, the frequency is stepped by 10 MHz, there is a cycle of nine grades between 20 MHz - 100 MHz, and the particle size of the particle obtained after atomization of the e-liquid can be adjusted arbitrarily. Of course, the frequency range and the grades can also be selected as other settings. When it is powered on again, the electronic cigarette starts the running according to the set data retained when it is powered off at the last time.

If there is not any operation within 40 s in the power-on state, the electric core 3 enters a standby power saving mode. After the button 5 is continuously pressed five times within 2 s in the power-on state, the electric core 3 is powered off, and the indicator light 6 flashes red for prompt. In the whole process, the indicator light 6 displays different colors according to the electric quantity of the battery from high to low, such as green (electric quantity > 70%), blue (electric quantity between 70% and 30%), and red (electric quantity < 30%). If the electric quantity of the battery is lower than 10% during use, the indicator light will flash and the electronic cigarette will automatically power off.

The atomization chip can also work in a continuous frequency range, such as 20 MHz - 100 MHz, and each frequency point corresponds to one smoke particle size after atomization of the e-liquid. According to the taste of the user, the smoke particle sizes can be set arbitrarily to obtain different smoke particle sizes.

The above only describes preferred embodiments of the present invention, and is not used to limit the present invention, wherein the scope of protection of the invention is defined by the appended claims.

## Claims

1. A variable-frequency surface acoustic wave electronic cigarette, comprising an atomizer (2); wherein an atomization cavity (213) is disposed in the atomizer (2), and a variable-frequency surface acoustic wave atomization chip (203) is disposed at a lower portion of the atomization cavity (213); an inverted trapezoidal interdigital transducer (2037) is disposed on the variable-frequency surface acoustic wave atomization chip (203); an e-liquid storage cavity (205)is disposed in the atomization cavity (213); and a porous ceramic sheet (204) is disposed between the e-liquid storage cavity (205) and the atomization chip (203);
wherein the inverted trapezoidal interdigital transducer (2037) comprises a plurality of metal interdigital electrodes (a, b) and reflective electrodes (c), which are in an inverted trapezoidal shape; the inverted trapezoidal interdigital transducer (2037) further comprises two metal electrode bus bars, namely a first metal electrode bus bar (20361) and a second metal electrode bus bar (20362); a plurality of first metal interdigital electrodes (a) are connected to the first metal electrode bus bar (20361) through a relatively long trapezoidal bottom, and a plurality of second metal interdigital electrodes (b) are connected to the second metal electrode bus bar (20362) through a relatively short trapezoidal bottom; the plurality of first metal interdigital electrodes (a) and the plurality of second metal interdigital electrodes (b) are arranged in a finger-crossed shape, and a reflective electrode (c) is embedded between a first metal interdigital electrode (a) and a second metal interdigital electrode (b).

2. The variable-frequency surface acoustic wave electronic cigarette of claim 1, wherein an arrangement manner of the metal interdigital electrodes and reflective electrodes is: the first metal interdigital electrode (*a*), a first gap (*d₁*), the second metal interdigital electrode *(b),* a second gap (*d₂*), the reflective electrode (c), a third gap (*d₃*), the first metal interdigital electrode (*a*), ... ; the above arrangement continues in a plurality of groups to constitute the inverted trapezoidal interdigital transducer (2037); an average width of the first gap (*d₁*) is identical to an average width of the first metal interdigital electrode (*a*); an average width of the second gap (*d₂*) is identical to an average width of the second metal interdigital electrode (b); and an average width of the third gap (*d₃*) is identical to an average width of the reflective electrode (c).

3. The variable-frequency surface acoustic wave electronic cigarette of claim 2, wherein a shape of the first metal interdigital electrode (*a*) and a shape of the second metal interdigital electrode (b)are identical; a sum of the average width of the first metal interdigital electrode (*a*), the average width of the first gap (*d₁*), the average width of the second metal interdigital electrode *(b),* the average width of the second gap (*d₂*), the average width of the reflective electrode (c) and the average width of the third gap (*d₃*) is a wavelength (p) of the surface acoustic wave; it is satisfied that the average width of the first metal interdigital electrode (*a*), or the average width of the first gap (*d₁*), or the average width of the second metal interdigital electrode (b) or the average width of the second gap *(d₂)* is one eighth of the wavelength of the surface acoustic wave, and the average width of the third gap (*d₃*) or the average width of the reflective electrode (c) is a quarter of the wavelength of the surface acoustic wave.

4. The variable-frequency surface acoustic wave electronic cigarette of claim 1, wherein the atomization chip (203) further successively comprises: a heat sink layer (2031), a heat conduction layer (2032) and a piezoelectric substrate layer (2033); the inverted trapezoidal interdigital transducer (2037) is disposed on the piezoelectric substrate layer (2033); two separate printed circuit board (PCB) bonding pads, namely a first PCB bonding pad (20341) and a second PCB bonding pad (20342), are further disposed on the piezoelectric substrate layer (2033); the first metal electrode bus bar (20361) is connected to the first PCB bonding pad (20341) through a power connection wire (2035), and the second metal electrode bus bar (20362) is connected to the second PCB bonding pad (20342) through a power connection wire (2035).

5. The variable-frequency surface acoustic wave electronic cigarette of claim 4, further comprising an electric core (3);wherein a circuit board (307) and a battery (305) are disposed in the electric core (3), and the electric core (3) is conductively connected to the first PCB bonding pad (20341) and the second PCB bonding pad (20342) through a magnetic thimble (212).

6. The variable-frequency surface acoustic wave electronic cigarette of claim 1, wherein the atomizer (2) is provided with an atomizer housing (209); an airflow channel (208) is disposed inside the atomizer housing (209), and a suction nozzle (1)is disposed outside the atomizer housing (209); the suction nozzle (1) is in communication with and connected to the airflow channel (208); an airflow inlet (210) is formed on the atomizer housing (209), and the airflow inlet (210) and the inverted trapezoidal interdigital transducer (2037) are on an identical horizontal plane.

7. The variable-frequency surface acoustic wave electronic cigarette of claim 5, further comprising a protective shell (301); wherein the electric core (3) is disposed in the protective shell (301); and a button (5), an indicator light (6) and a charging port (302) are disposed outside the protective shell (301).

## Patentansprüche

1. Eine elektronische Zigarette mit akustischen Oberflächenwellen variabler Frequenz, die einen Verdampfer (2) umfasst, wobei ein Verdampfungshohlraum (213) in dem Verdampfer (2) angeordnet ist und ein Verdampfungschip (203) mit akustischen Oberflächenwellen variabler Frequenz an einem unteren Abschnitt des Verdampfungshohlraums (213) angeordnet ist; ein invertierter trapezförmiger Interdigitalwandler (2037) auf dem Verdampfungschip (203) mit akustischen Oberflächenwellen variabler Frequenz angeordnet ist; ein E-Flüssigkeits-Speicherhohlraum (205) in dem Verdampfungshohlraum (213) angeordnet ist; und eine poröse Keramikplatte (204) zwischen dem E-Flüssigkeits-Speicherhohlraum (205) und dem Verdampfungschip (203) angeordnet ist;
wobei der invertierte trapezförmige Interdigitalwandler (2037) eine Vielzahl von Metall-Interdigitalelektroden (a, b) und reflektierenden Elektroden (c) umfasst, die eine invertierte Trapezform aufweisen; der invertierte trapezförmige Interdigitalwandler (2037) ferner zwei Metallelektroden-Sammelschienen umfasst, nämlich eine erste Metallelektroden-Sammelschiene (20361) und eine zweite Metallelektroden-Sammelschiene (20362); eine Vielzahl von ersten Metall-Interdigitalelektroden (a) mit der ersten Metallelektroden-Sammelschiene (20361) durch einen relativ langen trapezförmigen Boden verbunden sind, und eine Vielzahl von zweiten Metall-Interdigitalelektroden (b) mit der zweiten Metallelektroden-Sammelschiene (20362) durch einen relativ kurzen trapezförmigen Boden verbunden sind; die Vielzahl der ersten Metall-Interdigitalelektroden (a) und die Vielzahl der zweiten Metall-Interdigitalelektroden (b) in Form gekreuzter Finger angeordnet sind und eine reflektierende Elektrode (c) zwischen einer ersten Metall-Interdigitalelektrode (a) und einer zweiten Metall-Interdigitalelektrode (b) eingebettet ist.

2. Die elektronische Zigarette mit akustischen Oberflächenwellen variabler Frequenz nach Anspruch 1, wobei die Art der Anordnung der Metall-Interdigitalelektroden und reflektierenden Elektroden wie folgt ist: die erste Metall-Interdigitalelektrode (*a*), ein erster Spalt *(d1)*, die zweite Metall-Interdigitalelektrode *(b),* ein zweiter Spalt *(d2),* die reflektierende Elektrode (c), ein dritter Spalt *(d3),* die erste Metall-Interdigitalelektrode (*a*), ... ; die obige Anordnung setzt sich in einer Vielzahl von Gruppen fort, um den invertierten trapezförmigen Interdigitalwandler (2037) zu bilden; eine durchschnittliche Breite des ersten Spalts *(d1)* ist identisch mit einer durchschnittlichen Breite der ersten Metall-Interdigitalelektrode *(a)*; eine durchschnittliche Breite des zweiten Spalts *(d2)* ist identisch mit einer durchschnittlichen Breite der zweiten Metall-Interdigitalelektrode *(b);* und eine durchschnittliche Breite des dritten Spalts *(d3)* ist identisch mit einer durchschnittlichen Breite der reflektierenden Elektrode (c).

3. Die elektronische Zigarette mit akustischen Oberflächenwellen variabler Frequenz nach Anspruch 2, wobei eine Form der ersten Metall-Interdigitalelektrode *(a)* und eine Form der zweiten Metall-Interdigitalelektrode (b) identisch sind; eine Summe der durchschnittlichen Breite der ersten Metall-Interdigitalelektrode (*a*), der durchschnittlichen Breite des ersten Spalts *(d1),* der durchschnittlichen Breite der zweiten Metall-Interdigitalelektrode *(b),* der durchschnittlichen Breite des zweiten Spalts *(d2),* der durchschnittlichen Breite der reflektierenden Elektrode (c) und der durchschnittlichen Breite des dritten Spalts *(d3)* eine Wellenlänge *(p)* der akustischen Oberflächenwelle ist; es erfüllt ist, dass die durchschnittliche Breite der ersten Metall-Interdigitalelektrode *(a)* oder die durchschnittliche Breite des ersten Spalts *(d1)* oder die durchschnittliche Breite der zweiten Metall-Interdigitalelektrode (b) oder die durchschnittliche Breite des zweiten Spalts *(d2)* ein Achtel der Wellenlänge der akustischen Oberflächenwelle ist und die durchschnittliche Breite des dritten Spalts *(d3)* oder die durchschnittliche Breite der reflektierenden Elektrode (c) ein Viertel der Wellenlänge der akustischen Oberflächenwelle ist.

4. Die elektronische Zigarette mit akustischen Oberflächenwellen variabler Frequenz nach Anspruch 1, wobei der Verdampfungschip (203) ferner nacheinander umfasst: eine Wärmesenkenschicht (2031), eine Wärmeleitschicht (2032) und eine piezoelektrische Substratschicht (2033); der invertierte trapezförmige interdigitale Wandler (2037) auf der piezoelektrischen Substratschicht (2033) angeordnet ist; zwei separate Leiterplatten-Bondinseln, nämlich eine erste Leiterplatten-Bondinsel (20341) und eine zweite Leiterplatten-Bondinsel (20342), ferner auf der piezoelektrischen Substratschicht (2033) angeordnet sind; die erste Metallelektroden-Sammelschiene (20361) mit der ersten Leiterplatten-Bondinsel (20341) über einen Stromverbindungsdraht (2035) verbunden ist, und die zweite Metallelektroden-Sammelschiene (20362) mit der zweiten Leiterplatten-Bondinsel (20342) über einen Stromverbindungsdraht (2035) verbunden ist.

5. Die elektronische Zigarette mit akustischen Oberflächenwellen variabler Frequenz nach Anspruch 4, ferner umfassend einen elektrischen Kern (3); wobei eine Leiterplatte (307) und eine Batterie (305) in dem elektrischen Kern (3) angeordnet sind und der elektrische Kern (3) über eine magnetische Kausche (212) leitend mit der ersten Leiterplatten-Bondinsel (20341) und der zweiten Leiterplatten-Bondinsel (20342) verbunden ist.

6. Die elektronische Zigarette mit akustischen Oberflächenwellen variabler Frequenz nach Anspruch 1, wobei der Verdampfer (2) mit einem Verdampfergehäuse (209) versehen ist; ein Luftstromkanal (208) innerhalb des Verdampfergehäuses (209) angeordnet ist und eine Saugdüse (1) außerhalb des Verdampfergehäuses (209) angeordnet ist; die Saugdüse (1) mit dem Luftströmungskanal (208) in Verbindung steht und mit diesem kommuniziert; ein Luftströmungseinlass (210) an dem Verdampfergehäuse (209) ausgebildet ist und der Luftströmungseinlass (210) und der invertierte trapezförmige Interdigitalwandler (2037) auf einer identischen horizontalen Ebene liegen.

7. Die elektronische Zigarette mit akustischen Oberflächenwellen variabler Frequenz nach Anspruch 5, ferner umfassend eine Schutzhülle (301), wobei der elektrische Kern (3) in der Schutzhülle (301) angeordnet ist und ein Knopf (5), eine Anzeigeleuchte (6) und ein Ladeanschluss (302) außerhalb der Schutzhülle (301) angeordnet sind.

## Revendications

1. Cigarette électronique à onde acoustique de surface à fréquence variable, comprenant un atomiseur (2) ; dans laquelle une cavité d'atomisation (213) est disposée dans l'atomiseur (2), et une puce d'atomisation à onde acoustique de surface à fréquence variable (203) est disposée au niveau d'une partie inférieure de la cavité d'atomisation (213) ; un transducteur interdigital trapézoïdal inversé (2037) est disposé sur la puce d'atomisation à ondes acoustiques de surface à fréquence variable (203) ; une cavité de stockage de e-liquide (205) est disposée dans la cavité d'atomisation (213) ; et une feuille de céramique poreuse (204) est disposée entre la cavité de stockage de e-liquide (205) et la puce d'atomisation (203) ;
dans laquelle le transducteur interdigital trapézoïdal inversé (2037) comprend une pluralité d'électrodes interdigitales métalliques (a, b) et d'électrodes réfléchissantes (c), qui ont une forme trapézoïdale inversée ; le transducteur interdigital trapézoïdal inversé (2037) comprend en outre deux barres de bus d'électrode métallique, à savoir une première barre de bus d'électrode métallique (20361) et une seconde barre de bus d'électrode métallique (20362) ; une pluralité de premières électrodes interdigitales métalliques (a) sont connectées à la première barre de bus d'électrode métallique (20361) par un fond trapézoïdal relativement long, et une pluralité de secondes électrodes interdigitales métalliques (b) sont connectées à la seconde barre de bus d'électrode métallique (20362) par un fond trapézoïdal relativement court ; la pluralité de premières électrodes interdigitales métalliques (a) et la pluralité de secondes électrodes interdigitales métalliques (b) sont arrangées en forme de doigts croisés, et une électrode réfléchissante (c) est encastrée entre une première électrode interdigitale métallique (a) et une seconde électrode interdigitale métallique (b).

2. Cigarette électronique à ondes acoustiques de surface à fréquence variable selon la revendication 1, dans laquelle une manière d'arrangement des électrodes interdigitales métalliques et des électrodes réfléchissantes est : la première électrode interdigitale métallique (a), un premier espace (*d₁*), la deuxième électrode interdigitale métallique (b), un deuxième espace (*d*₂), l'électrode réfléchissante (c), un troisième espace (*d₃*), la première électrode interdigitale métallique (a), ... ; l'arrangement cidessus se poursuit en une pluralité de groupes pour constituer le transducteur interdigital trapézoïdal inversé (2037) ; une largeur moyenne du premier espace (*d₁*) est identique à une largeur moyenne de la première électrode interdigitale métallique (a) ; une largeur moyenne du deuxième espace (d2) est identique à une largeur moyenne de la deuxième électrode interdigitale métallique (b) ; et une largeur moyenne du troisième espace (d3) est identique à une largeur moyenne de l'électrode réfléchissante (c).

3. Cigarette électronique à ondes acoustiques de surface à fréquence variable selon la revendication 2, dans laquelle une forme de la première électrode interdigitale métallique (a) et une forme de la seconde électrode interdigitale métallique (b) sont identiques ; une somme de la largeur moyenne de la première électrode interdigitale métallique (a), de la largeur moyenne du premier espace (*d₁*), de la largeur moyenne de la deuxième électrode interdigitale métallique (b), de la largeur moyenne du deuxième espace (*d*₂), de la largeur moyenne de l'électrode réfléchissante (c) et de la largeur moyenne du troisième espace (*d₃*) est une longueur d'onde (p) de l'onde acoustique de surface ; il est satisfait que la largeur moyenne de la première électrode interdigitale métallique (a), ou la largeur moyenne du premier espace (*d₁*), ou la largeur moyenne de la deuxième électrode interdigitale métallique (b) ou la largeur moyenne du deuxième espace (*d*₂) est un huitième de la longueur d'onde de l'onde acoustique de surface, et la largeur moyenne du troisième espace (*d₃*) ou la largeur moyenne de l'électrode réfléchissante (c) est un quart de la longueur d'onde de l'onde acoustique de surface.

4. Cigarette électronique à ondes acoustiques de surface à fréquence variable selon la revendication 1, dans laquelle la puce d'atomisation (203) comprend en outre successivement : une couche de dissipateur thermique (2031), une couche de conduction thermique (2032) et une couche de substrat piézoélectrique (2033) ; le transducteur interdigital trapézoïdal inversé (2037) est disposé sur la couche de substrat piézoélectrique (2033) ; deux plages de de liaison de carte de circuit imprimé (PCB) séparées, à savoir une première plage de liaison de PCB (20341) et une deuxième plage de liaison de PCB (20342), sont en outre disposées sur la couche de substrat piézoélectrique (2033) ; la première barre de bus d'électrode métallique (20361) est connectée à la première plage de liaison de PCB (20341) par l'intermédiaire d'un fil de connexion d'alimentation (2035), et la deuxième barre de bus d'électrode métallique (20362) est connectée à la deuxième plage de liaison de PCB (20342) par l'intermédiaire d'un fil de connexion d'alimentation (2035).

5. Cigarette électronique à ondes acoustiques de surface à fréquence variable de la revendication 4, comprenant en outre un noyau électrique (3) ; dans laquelle une carte de circuit (307) et une batterie (305) sont disposées dans le noyau électrique (3), et le noyau électrique (3) est connecté de manière conductrice à la première plage de liaison de PCB (20341) et à la deuxième plage de liaison de PCB (20342) par l'intermédiaire d'une cosse magnétique (212).

6. Cigarette électronique à ondes acoustiques de surface à fréquence variable selon la revendication 1, dans laquelle l'atomiseur (2) est muni d'un boîtier d'atomiseur (209) ; un canal d'écoulement d'air (208) est disposé à l'intérieur du boîtier d'atomiseur (209), et une buse d'aspiration (1) est disposée à l'extérieur du boîtier d'atomiseur (209) ; la buse d'aspiration (1) est en communication avec et connectée au canal d'écoulement d'air (208) ; une entrée d'écoulement d'air (210) est formée sur le boîtier d'atomiseur (209), et l'entrée d'écoulement d'air (210) et le transducteur interdigital trapézoïdal inversé (2037) sont sur un plan horizontal identique.

7. Cigarette électronique à ondes acoustiques de surface à fréquence variable de la revendication 5, comprenant en outre une coque de protection (301) ; dans laquelle le noyau électrique (3) est disposé dans la coque de protection (301) ; et un bouton (5), un voyant lumineux (6) et une prise de chargement (302) sont disposés à l'extérieur de la coque de protection (301).
